# EUROPÄISCHE PATENTSCHRIFT

(11) **EP 2 263 094 B1**
(45) Veröffentlichungstag und Bekanntmachung des Hinweises auf die Patenterteilung: **09.05.2012**
(21) Anmeldenummer: 09725107.8
(22) Anmeldetag: 27.03.2009
(51) Int. Cl.: G01R 1/073, G01R 1/067

(54) **PRÜFKONTAKTANORDNUNG**
TEST CONTACT ARRANGEMENT
Agencement avec contanct de test

(30) Priorität: 27.03.2008 DE 102008016247
(43) Veröffentlichungstag der Anmeldung: 22.12.2010
(73) Patentinhaber: Pac Tech - Packaging Technologies GmbH, 14641 Nauen (DE)
(72) Erfinder: AZDASHT, Ghassem, 13591 Berlin (DE)
(74) Vertreter: Böck, Bernhard
(86) Internationale Anmeldenummer: PCT/DE2009/000393
(87) Internationale Veröffentlichungsnummer: WO 2009/117992

(56) Entgegenhaltungen:
- DE-A1- 19 926 701
- JP-A- 2003 035 723
- US-A1- 2002 055 282
- US-A1- 2007 296 433

## Beschreibung

Die vorliegende Erfindung betrifft eine Prüfkontaktanordnung zur Prüfung von Halbleiterbauelementen nach dem Oberbegriff des Anspruchs 1.

Prüfkontaktanordnungen, die regelmäßig mit einer Mehrzahl von auf einem Prüfkontaktrahmen angeordneten Prüfkontakten versehen sind, werden in der elektrischen Bauteiltestung von Halbleiterbauelementen, insbesondere Chips, eingesetzt und ermöglichen eine lediglich temporäre Verbindung der Anschlussflächen des Chips mit einer Prüfeinrichtung, die entsprechend einer vorgegebenen Prüfroutine eine Beaufschlagung des Bauteils mit Spannung ermöglicht.

Die bekannten Prüfkontaktanordnungen weisen hierzu einen im Wesentlichen als Platine nach Art eines Printed Circuit Boards (PCB) ausgebildeten Prüfkontaktrahmen auf, der auf seiner Oberseite mit den Prüfkontakten versehen ist, die zur temporären Kontaktierung mit dem Chip dienen, und auf seiner Unterseite Anschlusskontakte zur elektrischen Verbindung mit der Prüfeinrichtung aufweist. Die Verbindung zwischen den auf der Oberseite angeordneten Prüfkontakten und den auf der Unterseite angeordneten Anschlusskontakten erfolgt regelmäßig über in der Platine ausgebildete Durchkontaktierungen, die beispielsweise durch eine Leiterbahnstruktur ausgebildet sein können.

Aus der US 2002/0055282 A1 ist eine Prüfkontaktanordnung zur Prüfung von Halbleiterbauelementen bekannt, die auf der Oberfläche eines Prüfsubstrats angeordnete Prüfkontakte aufweist, die mit ihrer Befestigungsbasis mit Anschlussflächen einer im Prüfsubstrat ausgebildeten Leiterbahnstruktur elektrisch und mechanisch kontaktiert sind.

Insbesondere wegen deren Ausbildung der in das Platinenmaterial bzw. Substratmaterial integrierten Durchkontaktierungen ist die Herstellung der bekannten Prüfkontaktanordnungen mit einer Vielzahl von Verfahrensschritten verbunden und erweist sich demzufolge als entsprechend aufwendig.

Der Erfindung liegt die Aufgabe zugrunde, eine Prüfkontaktanordnung vorzuschlagen, die mit vergleichsweise geringem Fertigungsaufwand herstellbar ist.

Diese Aufgabe wird durch eine Prüfkontaktanordnung mit den Merkmalen des Anspruchs 1 gelöst.

Die erfindungsgemäße Prüfkontaktanordnung umfasst zumindest einen in einem Prüfkontaktrahmen angeordneten, nach Art eines Kragarms ausgebildeten Prüfkontakt mit einer Befestigungsbasis und einem mit der Befestigungsbasis verbundenen Kontaktarm mit Kontaktspitze, wobei die Befestigungsbasis mit einem Befestigungsfortsatz derart in eine Rahmenöffnung eingesetzt ist, dass ein Unterrand des Befestigungsfortsatzes im Wesentlichen flächenbündig mit einer Unterseite des Prüfkontaktrahmens ausgerichtet ist.

Aufgrund der den Querschnitt des Prüfkontaktrahmens im Bereich der Rahmenöffnung durchdringenden Ausbildung des Prüfkontakts ermög-licht der Prüfkontakt über seinen Kontaktarm nicht nur die Kontaktierung mit dem zu prüfenden Bauteil, sondern ermöglicht darüber hinaus auch über den mit seiner Unterkante im Wesentlichen flächenbündig mit der Unterseite des Prüfkontaktrahmens ausgerichteten Befestigungsfortsatz die Ausbildung eines Anschlusskontakts zur direkten Kontaktierung mit der Prüfeinrichtung, ohne das unabhängig vom Prüfkontakt die Ausbildung von Durchkontaktierungen im Prüfkontaktrahmen notwendig wäre.

Vielmehr wird aufgrund der erfindungsgemäßen Ausgestaltung der Prüfkontaktanordnung die Funktion einer Durchkontaktierung vom Prüfkontakt übernommen, so dass diesem eine Doppelfunktion zukommt, nämlich zum einen die Kontaktierung mit dem zu prüfenden Bauteil und zum anderen über die Befestigungsbasis bzw. den Befestigungsfortsatz eine elektrisch leitende Verbindung zwischen dem auf der Oberseite des Prüfkontaktrahmens angeordneten Kontaktarm und der Unterseite des Prüfkontaktrahmens nach Art einer Durchkontaktierung herstellt. Zur Erfüllung dieser Doppelfunktion ist es im Grundsatz zunächst einmal unwesentlich, ob die Unterkante des Befestigungsfortsatzes exakt bündig mit der Oberfläche der Unterseite des Prüfkontaktrahmens ausgerichtet ist, oder gegenüber dieser leicht zurückspringt oder aus dieser hervorragt, solange eine direkte elektrisch leitfähige Verbindung zwischen der Unterkante des Befestigungsfortsatzes und Kontakten einer Prüfeinrichtung herstellbar ist, ohne dass hierzu die Ausbildung weiterer Leiterstrecken notwendig wäre.

Bei einer bevorzugten Ausführungsform der Prüfkontaktanordnung ist die Befestigungsbasis in einem Abstand a zur Unterkante mit zumindest einem Positionierungsanschlag versehen, wobei der Abstand a der Dicke des Prüfkontaktrahmens entspricht. Derart ausgestaltet ist bei der Herstellung der Prüfkontaktanordnung die vorstehend erläuterte, im Wesentlichen flächenbündige Ausrichtung der Unterkante des Befestigungsfortsatzes des Prüfkontakts mit der Unterseite des Prüfkontaktrahmens zwangsläufig gegeben, wenn bei einem Einsetzen des Prüfkontakts in die Rahmenöffnung der Positionierungsanschlag gegen die Oberseite des Prüfkontaktrahmens anschlägt.

Vorteilhaft ist es auch, wenn die Passung zwischen dem in die Rahmenöffnung eingesetzten Befestigungsfortsatz des Prüfkontakts und der Rahmenöffnung als Presspassung ausgelegt ist, so dass sich bei einem Einsetzen des Prüfkontakts in die Rahmenöffnung ein Klemmkontakt zwischen dem Prüfkontakt und dem Prüfkontaktrahmen ausbildet und je nach Größe der derart erzeugten Klemmkräfte zumindest eine vorläufige Fixierung des Prüfkontakts im Prüfkontaktrahmen gegeben ist, die die Herstellung einer anschließend erzeugten, dauerhaften Verbindung zwischen dem Prüfkontakt und dem Prüfkontaktrahmen erleichtert.

Wenn der Prüfkontaktrahmen und der Prüfkontakt über eine auf der Unterseite des Prüfkontaktrahmens ausgebildete Lotmaterialverbindung miteinander verbunden sind, ist die Herstellung einer dauerhaften mechanischen Verbindung mit minimalem Aufwand möglich, und gleichzeitig hiermit können erhöhte Kontaktmetallisierungen ausgebildet werden, die nach Art von "Lot-Bumps" Anschlusskontakte ausbilden, die mit der Prüfeinrichtung unmittelbar kontaktierbar sind.

Wenn darüber hinaus die Lotmaterialverbindung zwischen zumindest einer auf der Unterseite angeordneten, elektrisch leitfähig ausgebildeten Kontaktstelle und der Unterkante des Befestigungsfortsatzes des Prüfkontakts ausgebildet ist, wird die Herstellung einer mechanisch besonders belastbaren und im Betrieb entsprechend zuverlässigen Lötverbindung zwischen dem Prüfkontakt und dem Prüfkontaktrahmen möglich. Derartige Kontaktstellen können beispielsweise durch an sich bekannte Kontaktmaterialaufträge erzeugt werden, die fachsprachig auch als sogenannte "Under Bump Metallization" (UBM) bekannt sind und beispielsweise eine Gold- oder Nickel/Gold-Beschichtung auf einem auf das an sich nicht leitende Material des Prüfkontaktrahmens aufgebrachten Haftvermittler aufweisen.

Wenn sich die Kontaktstelle an einem Öffnungsrand der Rahmenöffnung befindet, ist es aufgrund der zur Unterkante des Befestigungsfortsatzes unmittelbar benachbarten Anordnung der Kontaktstelle möglich, zur Herstellung der Lotmaterialverbindung ein Lotmaterialdepot mit möglichst geringer Masse zu verwenden. Somit ist es auch möglich, eine Lotmaterialverbindung durch ein beispielsweise in einem Ejektionsverfahren auf die Kontaktstelle geschleudertes Lotmaterialdepot mit anschließendem Umschmelzvorgang herzustellen.

Wenn gemäß einer bevorzugten Ausführungsform die im Prüfkontaktrahmen angeordnete Rahmenöffnung zwei parallele, in einer Ebenenrichtung des Prüfkontaktrahmens verlaufende Öffnungsränder aufweist, zwischen denen in einer Reihenanordnung eine Mehrzahl von Prüfkontakten mit ihren Befestigungsfortsätzen angeordnet sind, derart, dass die Kontaktarme quer zu der Ebenenrichtung ausgerichtet sind, ist es möglich mit einer derart gebildeten Prüfkontakt-Reihenanordnung eine gleichzeitige Kontaktierung von in einer entsprechenden Reihenanordnung angeordneten Anschlusskontakten des zu prüfenden Bauelements in einem einzigen Kontaktvorgang durchzuführen.

Wenn darüber hinaus der Prüfkontaktrahmen eine Mehrzahl von in einer Matrixanordnung angeordneten Rahmenöffnungen aufweist, die jeweils mit einer Prüfkontakt-Reihenanordnung versehen sind, kann die Prüfkontaktanordnung zur gleichzeitigen Kontaktierung mit einer Mehrzahl von zu prüfenden Bauelementen, die jeweils in einer Reihenanordnung Anschlussflächen aufweisen, verwendet werden.

Besonders vorteilhaft ist es, wenn die Matrixanordnung eine Mehrzahl jeweils einem Bauelement zugeordnete Gruppen mit zumindest zwei zueinander parallel angeordneten Rahmenöffnungen aufweist, die jeweils mit einer Prüfkontakt-Reihenanordnung versehen sind, derart, dass an den Enden der Kontaktarme ausgebildete Kontaktspitzen in einer Kontaktspitzenanordnung entsprechend einer Anschlussflächenanordnung des zu prüfenden Bauelements angeordnet sind. Derart ausgebildet ermöglicht die Prüfkontaktanordnung eine Prüfung von Halbleiterbauelementen auf Waferebene, also beispielsweise die Prüfung eines Wafers mit einer Mehrzahl von in einem Verbund angeordneten Halbleiterbauelementen noch vor deren Vereinzelung aus dem Waferverbund.

Nachfolgend werden bevorzugte Ausführungsformen anhand der Zeichnung näher erläutert.

Es zeigen:
- **Fig. 1**: einen in eine Rahmenöffnung eines Prüfkontaktrahmens eingesetzten Prüfkontakt mit auf der Unterseite des Prüfkontaktrahmens ausgebildeten Lotmaterialverbindungen;
- **Fig. 2**: einen mit Prüfkontakten bestückten Prüfkontaktrahmen während der Herstellung der Lotmaterialverbindungen;
- **Fig. 3**: eine mit einer Prüfeinrichtung kontaktierte Prüfkontaktanordnung mit einer Prüfkontakt-Reihenanordnung;
- **Fig. 4**: eine Draufsicht auf eine Prüfkontaktanordnung mit einer Mehrzahl von in Matrixanordnung angeordneten, jeweils einem zu prüfenden Bauelement zugeordneten Prüfkontakt-Reihenanordnungen.

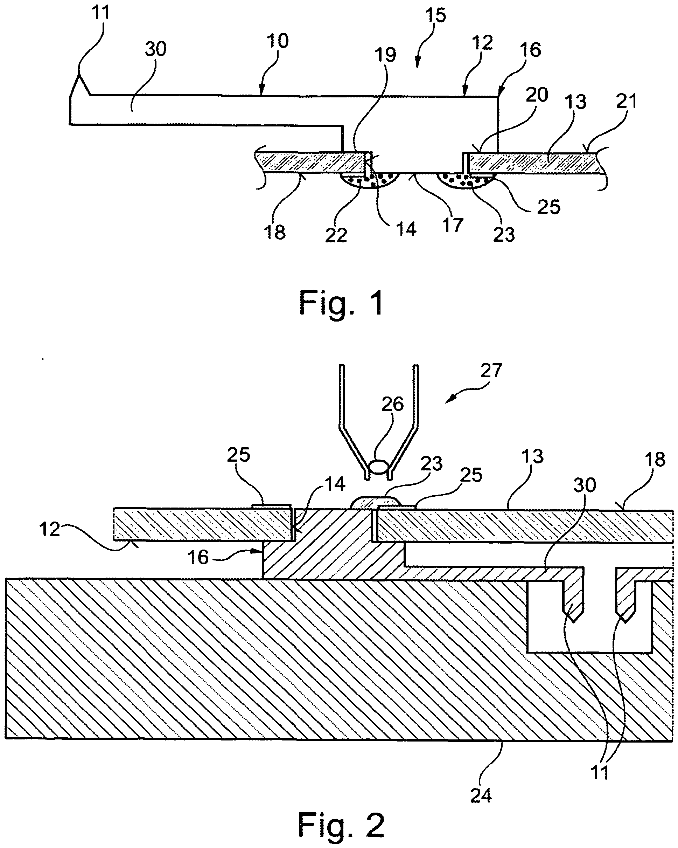

**Fig. 1** zeigt einen nachfolgend als Prüfkontakt 10 bezeichneten Prüfausleger, der an einem Kragarm 30 eine Kontaktspitze 11 aufweist und mit einer am gegenüberliegenden Ende des Kragarms 30 ausgebildeten Befestigungsbasis 12 mit einem Prüfkontaktrahmen 13 verbunden ist, der eine sich senkrecht zur Zeichnungsebene erstreckende Rahmenöffnung 14 aufweist.

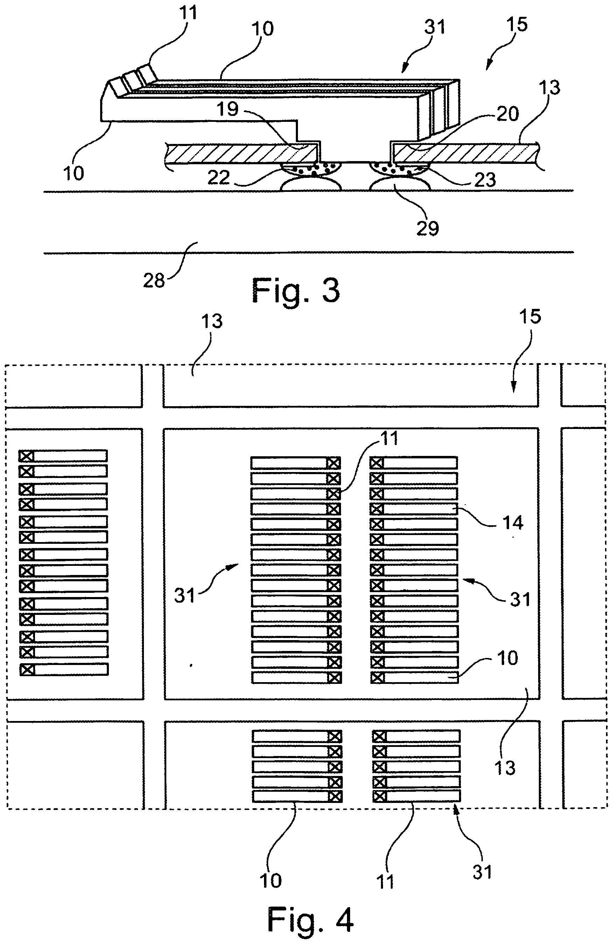

Wie aus der Darstellung gemäß Fig. 3 hervorgeht, dient die Rahmenöffnung 14 zur befestigenden Aufnahme einer Mehrzahl von parallel zueinander angeordneten Prüfkontakten 10, die im vorliegenden Fall gleichmäßig voneinander beabstandet sind. Die Prüfkontakte 10 bilden zusammen mit dem Prüfkontaktrahmen 13 eine Prüfkontaktanordnung 15.

Wie die **Fig. 1** zeigt, greift im vorliegenden Ausführungsbeispiel die Befestigungsbasis 12 mit einem Befestigungsfortsatz 16 derart in die Rahmenöffnung 14 ein, dass eine Unterkante 17 des Befestigungsfortsatzes 16 im Wesentlichen flächenbündig mit einer Unterseite 18 des aus einem elektrisch isolierenden Material bestehenden Prüfkontaktrahmens 13 ausgerichtet ist. Dabei liegen Positionierungsanschläge 19, 20 der Befestigungsbasis 12 gegen eine Oberseite 21 des Prüfkontaktrahmens 13 an.

Über den in **Fig. 1** dargestellten, vorzugsweise formschlüssigen Eingriff des Befestigungsfortsatzes 16 in die Rahmenöffnung 14 des Prüfkontaktrahmens 13 ergibt sich bereits eine gewisse Fixierung des Prüfkontakts 10 gegenüber dem Prüfkontaktrahmen 13, so dass in dieser Position eine feste mechanische Verbindung des Prüfkontakts 10 mit dem Prüfkontaktrahmen 13 über Lotmaterialverbindungen 22, 23 erfolgen kann.

Zur Herstellung der Lotmaterialverbindungen 22, 23 sowie gegebenenfalls auch bereits zur vorhergehenden Fixierung des Prüfkontakts 10 im Prüfkontaktrahmen 13, sind die Prüfkontakte 10 entsprechend der Darstellung in **Fig. 2** mit nach oben gerichteter Befestigungsbasis 12 auf einer Montageplattform 24 angeordnet. Die Montageplattform 24 weist auf ihrer Oberseite eine Vertiefung auf, in die die Kontaktspitzen 11 zur Ermöglichung einer flächigen Auflage des Kragarms 30 auf der Montageplattform 24 eingreifen.

In dieser Positionierung der Prüfkontakte 10, die, wie in **Fig. 4** dargestellt, mit einander zugewandten Kragarmen 30 in zwei parallelen Rahmenöffnungen 14 des Prüfkontaktrahmens 13 angeordnet sind, wird die Unterkante 17 der Prüfkontakte 10 bzw. der Befestigungsfortsätze 16 mit an Rändern der Rahmenöffnungen 14 angeordneten Kontaktmetallisierungen 25 vermittels der Applikation eines Lotmaterialdepots 26 zur Herstellung der Lotmaterialverbindungen 22, 23 verbunden. Die Kontaktmetallisierungen 25 auf dem Prüfkontaktrahmen 13 können vorteilhaft aus einer Goldmetallisierung bestehen.

Wie **Fig. 2** ferner zeigt, erfolgt die Applikation der Lotmaterialdepots 26 auf die Unterkante 17 bzw. die Kontaktmetallisierungen 25 des Prüfkontaktrahmens 13 derart, dass über eine Lotmaterial-Ejektionseinrichtung 27 ein Lotmaterialdepot 26 gegen eine Kontaktmetallisierung 25 sowie den angrenzenden Bereich der Unterkante 17 des elektrisch leitenden, vorzugsweise metallisch ausgebildeten Prüfkontakts 10 geschleudert wird. Hierzu wird das Lotmaterialdepot 26 in der Lotmaterial-Ejektionseinrichtung 27 zumindest teilweise durch Beaufschlagung mit Laserenergie verflüssigt und anschließend unter Druckluftbeaufschlagung gegen die Verbindungsstelle geschleudert.

Wie **Fig. 3** zeigt, erfolgt die Kontaktierung der Prüfkontaktanordnung 15 mit einer Prüfplattform 28, die zur elektrischen Überprüfung von Halbleiterbauelementen dient, derart, dass die durch die Lotmaterialverbindungen 22, 23 gebildeten Anschlusskontakte mit Prüfanschlüssen 29 der Prüfplattform 28 verbunden werden.

**Fig. 4** zeigt die Prüfkontaktanordnung 15 mit einer Mehrzahl von Prüfkontakt-Reihenanordnungen 31 in einer Matrixanordnung, wobei jeweils zwei parallele und mit ihren Kragarmen 30 einander zugewandte Prüfkontakt-Reihenordnungen 31 zur Kontaktierung mit einem Bauelement dien.

Die Prüfkontakt-Reihenanordnungen 31 sind insbesondere so auf der Prüfplattform 28 angeordnet, dass jeweils zwei parallele Prüfkontakt-Reihenanordnungen 31 einem in einem Waferverbund angeordneten elektronischen Bauelement zugeordnet ist. Derartige elektronische Bauelemente können beispielsweise als Memory-Chips ausgebildet sein, wobei jede Kontaktspitze 11 einer Prüfkontakt-Reihenanordnung 31 mit einem Anschlusskontakt des Memory-Chips verbunden werden kann.

Über eine an der Peripherie der Prüfplattform 28 angeschlossene Prüfeinrichtung können dann gezielt mittels einer in der Prüfplattform 28 realisierten Leiteranordnung die einzelnen Memory-Chips durch Auflegen des Wafers auf die Mehrzahl von Prüfkontakt-Reihenanordnungen 31 getestet werden.

Die in **Fig. 3** dargestellte elektrisch leitende Verbindung zwischen den Lotmaterialverbindungen 22, 23 der Prüfkontaktanordnung 15 und den Prüfanschlüssen 29 der Prüfplattform 28 kann in einem Reflow-Verfahren erfolgen.

## Patentansprüche

1. Prüfkontaktanordnung (15) zur Prüfung von Halbleiterbauelementen mit zumindest einem nach Art eines Kragarms ausgebildeten Prüfkontakt (10) mit einer Befestigungsbasis (12) und einem mit der Befestigungsbasis verbundenen Kontaktarm (30) mit Kontaktspitze (11),
**dadurch gekennzeichnet,**
**dass** die Befestigungsbasis zur befestigenden Aufnahme mit einem Befestigungsfortsatz (16) in eine als Fensteröffnung ausgebildete Rahmenöffnung (14) eines Prüfkontaktrahmens (13) derart eingreift, dass eine Unterkante (17) des Befestigungsfortsatzes bis zu einer Unterseite (18) des Prüfkontaktrahmens reicht.

2. Prüfkontaktanordnung nach Anspruch 1,
**dadurch gekennzeichnet,**
**dass** die Befestigungsbasis (12) in einem Abstand a zur Unterkante (17) zumindest einen Positionierungsanschlag (19, 20) aufweist, wobei der Abstand a der Dicke des Prüfkontaktrahmens (13) entspricht.

3. Prüfkontaktanordnung nach Anspruch 1 oder 2,
**dadurch gekennzeichnet,**
**dass** die Passung zwischen dem in die Rahmenöffnung (14) eingesetzten Befestigungsfortsatz (16) des Prüfkontakts (10) und der Rahmenöffnung (14) als Presspassung ausgelegt ist.

4. Prüfkontaktanordnung nach einem der vorangehenden Ansprüche,
**dadurch gekennzeichnet,**
**dass** der Prüfkontaktrahmen (13) und der Prüfkontakt (10) über eine auf der Unterseite (18) des Prüfkontaktrahmens ausgebildete Lotmaterialverbindung (22, 23) miteinander verbunden sind.

5. Prüfkontaktanordnung nach Anspruch 4,
**dadurch gekennzeichnet,**
**dass** die Lotmaterialverbindung (22, 23) zwischen zumindest einer auf der Unterseite (18) angeordneten ,elektrisch leitfähig ausgebildeten Kontaktfläche und der Unterkante (18) des Befestigungsfortsatzes (16) des Prüfkontakts (10) ausgebildet ist.

6. Prüfkontaktanordnung nach Anspruch 5,
**dadurch gekennzeichnet,**
**dass** die Kontaktfläche aus einer auf die Oberfläche des aus einem elektrisch nicht leitenden Material gebildeten Prüfkontaktrahmens (13) aufgebrachten, elektrisch leitenden Kontaktmaterial (25) gebildet ist.

7. Prüfkontaktanordnung nach Anspruch 5 oder 6,
**dadurch gekennzeichnet,**
**dass** die Kontaktfläche an einem Öffnungsrand der Rahmenöffnung (14) angeordnet ist.

8. Prüfkontaktanordnung nach einem der vorangehenden Ansprüche,
**dadurch gekennzeichnet,**
**dass** die im Prüfkontaktrahmen (13) angeordnete Rahmenöffnung (14) zwei parallele, in einer Ebenenrichtung des Prüfkontaktrahmens (13) verlaufende Öffnungsränder aufweist, zwischen denen in einer Prüfkontakt-Reihenanordnung (31) eine Mehrzahl von Prüfkontakten (10) mit ihren Befestigungsfortsätzen (16) angeordnet ist, derart, dass die Kontaktarme (30) quer zu der Ebenenrichtung ausgerichtet sind.

9. Prüfkontaktanordnung nach Anspruch 8,
**dadurch gekennzeichnet,**
**dass** der Prüfkontaktrahmen (13) eine Mehrzahl von in einer Matrixanordnung angeordneten Rahmenöffnungen (14) aufweist, die jeweils mit einer Prüfkontakt-Reihenanordnung (31) versehen sind.

10. Prüfkontaktanordnung nach Anspruch 9,
**dadurch gekennzeichnet,**
**dass** die Matrixanordnung eine Mehrzahl von jeweils einem zu prüfenden Halbleiterbauelement zugeordneten Rahmenöffnungs-Gruppen mit zumindest zwei zueinander parallel angeordneten Rahmenöffnungen (14) aufweist, die jeweils mit einer Prüfkontakt-Reihenanordnung (31) versehen sind, derart, dass die an den Kontaktarmen (30) ausgebildeten Kontaktspitzen (11) in einer Kontaktspitzenanordnung entsprechend einer Anschlussflächenanordnung der zu prüfenden Halbleiterbauelemente angeordnet sind.

## Claims

1. Test contact arrangement (15) for testing semiconductor components, comprising at least one test contact (10) which is designed in the type of a cantilever arm and which has a fastening base (12) and a contact arm (30) being provided with a contact tip (11) and being connected to the fastening base,
**characterized in that**
for the purpose of a fixing accommodation the fastening base is inserted with a fastening projection (16) thereof into a frame opening (14) of a test contact frame (13), the frame opening being designed as a window opening, in such a manner that a lower edge (17) of the fastening projection reaches a lower side (18) of the test contact frame.

2. Test contact arrangement according to claim 1,
**characterized in that**
the fastening base (12) has at least one positioning stop (19, 20) at a distance a from the lower edge (17), wherein the distance a corresponds to the thickness of the test contact frame (13).

3. Test contact arrangement according to claim 1 or 2,
**characterized in that**
the fitting engagement between the fastening projection (16) of the test contact (10), which is inserted into the frame opening (14), and the frame opening (14) is configured as a press-fit engagement.

4. Test contact arrangement according to any of the preceding claims,
**characterized in that**
the test contact frame (13) and the test contact (10) are connected to one another via a solder material connection (22, 23) formed on the lower side (18) of the test contact frame.

5. Test contact arrangement according to claim 4,
**characterized in that**
the solder material connection (22, 23) is formed between at least one contact surface, which is arranged on the lower side (18) and which is formed in an electrically conductive manner, and the lower edge (18) of the fastening projection (16) of the test contact (10).

6. Test contact arrangement according to claim 5,
**characterized in that**
the contact surface is formed of an electrically conductive contact material (25) applied to the surface of the test contact frame (13) which is formed of an electrically non-conductive material.

7. Test contact arrangement according to claim 5 or 6,
**characterized in that**
the contact surface is arranged at an opening edge of the frame opening (14).

8. Test contact arrangement according to any of the preceding claims,
**characterized in that**
the frame opening (14) arranged in the test contact frame (13) has two parallel opening edges which extend in a plane direction of the test contact frame (13), a plurality of test contacts (10) with their fastening projections (16) being arranged in a test contact row arrangement (31) between the opening edges in such a manner that the contact arms (30) are aligned transverse to the plane direction.

9. Test contact arrangement according to claim 8,
**characterized in that**
the test contact frame (13) has a plurality of frame openings (14) which are disposed in a matrix arrangement and are each provided with a test contact row arrangement (31).

10. Test contact arrangement according to claim 9,
**characterized in that**
the matrix arrangement has a plurality of frame opening groups which are each assigned to a semiconductor component to be tested and comprise at least two frame openings (14) which are disposed in parallel to one another and which are each provided with a test contact row arrangement (31) in such a manner that the contact tips (11) formed at the contact arms (30) are arranged in a contact tip arrangement corresponding to a terminal face arrangement of the semiconductor components to be tested.

## Revendications

1. Agencement de contacts d'essai pour tester des composants semiconducteurs, comprenant au moins un contact d'essai (10) qui est conçu sous la forme d'un bras en porte-à-faux et qui présente une base de fixation (12) et un bras de contact (30) étant muni d'une pointe de contact (11) et étant relié avec la base de fixation,
**caractérisé en ce que**
la base de fixation avec une saillie de fixation (16) est insérée dans un orifice de cadre (14) d'un cadre de contacts d'essai (13) afin de réaliser un logement fixant, l'orifice de cadre étant conçu en tant qu'embrasure de fenêtre, de telle manière qu'un bord inférieur (17) de la saillie de fixation atteigne un côté inférieur (18) du cadre de contacts d'essai.

2. Agencement de contacts d'essai selon la revendication 1,
**caractérisé en ce que**
la base de fixation (12) présente au moins une butée de positionnement (19, 20) à une distance a d'un bord inférieur (17), la distance a correspondant à l'épaisseur du cadre de contacts d'essai (13).

3. Agencement de contacts d'essai selon la revendication 1 ou 2,
**caractérisé en ce que**
l'ajustage entre la saillie de fixation (16) du contact d'essai (10), qui est insérée dans l'orifice de cadre (14), et l'orifice de cadre (14) est réalisé en tant qu'ajustage serré.

4. Agencement de contacts d'essai selon l'une quelconque des revendications précédentes,
**caractérisé en ce que**
le cadre de contacts d'essai (13) et le contact d'essai (10) sont reliés entre eux via une connexion par un matériau de brasage (22, 23) formée sur le côté inférieur (18) du cadre de contacts d'essai.

5. Agencement de contacts d'essai selon la revendication 4,
**caractérisé en ce que**
la connexion par un matériau de brasage (22, 23) est formée entre au moins une surface de contact, qui est agencée sur le côté inférieur (18) et qui est formée de manière à être électriquement conductrice, et le bord inférieur (18) de la saillie de fixation (16) du contact d'essai (10).

6. Agencement de contacts d'essai selon la revendication 5,
**caractérisé en ce que**
la surface de contact est formée d'un matériau de contact électriquement conducteur (25) étant appliqué sur la surface du cadre de contacts d'essai (13) qui est formé d'un matériau électriquement non-conducteur.

7. Agencement de contacts d'essai selon la revendication 5 ou 6,
**caractérisé en ce que**
la surface de contact est agencée à un bord d'ouverture de l'orifice de cadre (14).

8. Agencement de contacts d'essai selon l'une quelconque des revendications précédentes,
**caractérisé en ce que**
l'orifice de cadre (14) étant agencé dans le cadre de contacts d'essai (13) présente deux bords d'ouverture parallèles s'étendant dans une direction du plan du cadre de contacts d'essai (13), une pluralité de contacts d'essai (10) avec leurs saillies de fixation (16) étant agencés dans un agencement de rangées de contacts d'essai (31) entre les bords d'ouverture de telle manière que les bras de contact (30) soient alignés transversalement par rapport à la direction du plan.

9. Agencement de contacts d'essai selon la revendication 8,
**caractérisé en ce que**
le cadre de contacts d'essai (13) présente une pluralité d'orifices de cadre (14) qui sont disposés dans un agencement de matrice et qui sont chacun munis d'un agencement de rangées de contacts d'essai (31).

10. Agencement de contacts d'essai selon la revendication 9,
**caractérisé en ce que**
l'agencement de matrice présente une pluralité de groupes d'orifices de cadre qui sont chacun associés à un composant semi-conducteur à tester et qui comprennent au moins deux orifices de cadre (14) qui sont agencés en parallèle l'un à l'autre et qui sont chacun munis d'un agencement de rangées de contacts d'essai (31) de telle manière que les pointes de contact (11) formées aux bras de contact (30) sont agencées dans un agencement de pointes de contact conformément à un agencement de faces de raccordement des composants semiconducteurs à tester.
